(19) Europäisches Patentamt / European Patent Office / Office européen des brevets

(11) **EP 2 192 416 B1**

(12) **EUROPEAN PATENT SPECIFICATION**

(45) Date of publication and mention
of the grant of the patent:
**03.01.2018 Bulletin 2018/01**

(51) Int Cl.:
*G01R 31/02* *(2006.01)*  *G01R 31/08* *(2006.01)*

(21) Application number: **08169969.6**

(22) Date of filing: **26.11.2008**

(54) **Method and apparatus for detecting a phase-to-earth fault**

Verfahren und Vorrichtung zur Erkennung eines einpoligen Erdschlusses

Procédé et appareil pour détecter le défaut de phase à la terre

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**02.06.2010 Bulletin 2010/22**

(73) Proprietor: **ABB Schweiz AG**
**5400 Baden (CH)**

(72) Inventors:
• **Wahlroos, Ari**
**65350 Vaasa (FI)**
• **Altonen, Janne**
**37800 Toijala (FI)**

(74) Representative: **Kolster Oy Ab**
**(Salmisaarenaukio 1)**
**P.O. Box 204**
**00181 Helsinki (FI)**

(56) References cited:
**EP-A- 1 195 875     WO-A-03/023429**

• **LORENC J ET AL: "Admittance criteria for earth fault detection in substation automation systems in Polish distribution power networks", ELECTRICITY DISTRIBUTION. PART 1: CONTRIBUTIONS. CIRED. 14TH INTERNATIONAL CONFERENCE AND EXHIBITION ON (IEE CONF. PUBL. NO. 438), LONDON, UK, IEE, UK, vol. 4, 2 June 1997 (1997-06-02), pages 19/1-19/5, XP006506450, ISBN: 978-0-85296-674-7**

**Description**

FIELD OF THE INVENTION

The present invention relates to detecting a phase-to-earth fault on a three-phase electric line of an electric network.

BACKGROUND OF THE INVENTION

In certain countries, such as Poland, the neutral admittance protection has become a common earth fault protection function. It has been reported to provide better effectiveness in earth fault detection when compared to the traditional residual current based earth fault protection in unearthed and compensated distribution networks.

Document J. Lorenc et. al, Admittance criteria for earth fault detection in substation automation systems in Polish distribution power networks, CIRED 97, Birmingham, June 1997, discloses examples of the implementation of the neutral admittance based earth fault protection and mentions that until mid-1996 over 2000 neutral admittance protection systems have been installed in Poland.

In simple terms, neutral admittance protection is based on evaluating the quotient $\underline{Y}_0 = 3\underline{I}_0/\underline{U}_0$, i.e. neutral admittance of the network, and comparing the result with operating boundaries in an admittance plane. Residual current $3\underline{I}_0$ is typically measured with a cable core transformer and residual voltage $\underline{U}_0$ is measured from open-delta connected tertiaries of single-pole isolated voltage transformers.

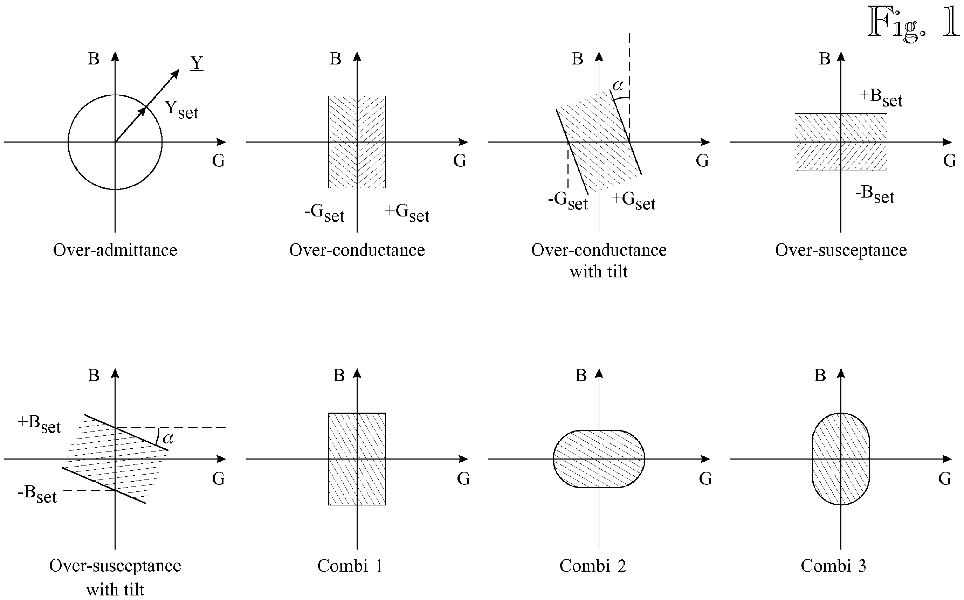

Currently, the admittance protection found in existing protection relay terminals typically requires the user to select the operation criteria from several possibilities such as 1) over-admittance, 2) over-conductance (non-dir or forward/reverse directional) without/with tilt, 3) over-susceptance (non-dir or forward/reverse directional) without/with tilt or a combination of criteria 1...3 (symmetrical around the origin). Figure 1 shows examples of operation characteristics of existing admittance protection functions presented on an admittance plane (B is susceptance and G is conductance). The shaded area in each of the operation characteristics determines the normal or non-operation area such that, if the neutral admittance is within this area, the protection does not operate and, if the neutral admittance is outside this area, then the protection operates. For example, the over-admittance operation characteristic may be defined by setting an absolute value $Y_{set}$ of admittance $\underline{Y}$ which defines a circle on the admittance plane as shown. The over-conductance operation characteristic may be defined by lower ($-G_{set}$) and upper ($+G_{set}$) conductance settings and a tilt may be further set with an angle setting $\alpha$ as shown. In a similar manner, the over-susceptance operation characteristic may be defined by lower ($-B_{set}$) and upper ($+B_{set}$) susceptance settings and a tilt may be further set with an angle setting a. It should be noted that in the over-conductance and over-susceptance characteristics illustrated in Figure 1 the shaded non-operation area and the lines defining them have been shown only partly, for the sake of clarity. In addition, different combinations of the operation characteristics can be formed by combining the settings such that e.g. both the over-conductance and over-susceptance settings are applied at the same time.

In existing solutions, the operation characteristic to be used depends on the network neutral point treatment. For example, in isolated networks the over-susceptance criteria should be applied. In compensated networks it is advised to use the over-conductance based criteria instead. This means that a relay terminal with admittance protection functionality requires many settings which need to be set according to the network properties. The many settings and possibly difficult setting calculation procedures are a problem with such existing solutions. EP1195875A2 relates to a method for identification of an impending fault condition in an electrical distribution system such as a compensated network.

BRIEF DESCRIPTION OF THE INVENTION

An object of the present invention is to provide a method and an apparatus for implementing the method so as to overcome the above problem or at least to alleviate the problem. The objects of the invention are achieved by a method, a computer program product and an apparatus which are characterized by what is stated in the independent claims. The preferred embodiments of the invention are disclosed in the dependent claims.

The invention is based on the idea of utilizing zero sequence currents and voltages before an earth fault and during the earth fault for determining a neutral admittance, and comparing the determined neutral admittance, or a quantity indicative thereof, to a predetermined operation characteristic to detect a phase-to-earth fault on the three-phase electric line, wherein the predetermined operation characteristic, when presented on an admittance plane, defines a closed area such that the centre of the closed area is offset from the origin of the admittance plane towards a negative susceptance direction and/or towards a negative conductance direction.

An advantage of the invention is that it provides a simplified operation function and characteristic, which can at the same time be valid for unearthed networks, high resistance earthed and/or compensated networks. Therefore, no change in the setting values are needed, if e.g. the earthing method is changed by e.g. disconnection of a compensation coil. In addition, the invention provides immunity against fault resistance and system unbalance by using delta-quantities in neutral admittance calculation. Therefore, a high sensitivity in terms of how high fault resistance can be detected can be obtained.

BRIEF DESCRIPTION OF THE DRAWINGS

In the following the invention will be described in greater detail by means of preferred embodiments with reference to the accompanying drawings, in which

Figure 1 shows examples of operation characteristics of admittance protection functions;
Figure 2 is a simplified equivalent circuit for a three-phase electric network;
Figure 3 is a simplified equivalent circuit for a three-phase electric network;
Figure 4 is an example of an operation characteristic according to an embodiment;
Figure 5 is an example of an operation characteristic according to an embodiment; and
Figure 6 is a diagram illustrating an embodiment implementing several protection stages.

DETAILED DESCRIPTION OF THE INVENTION

The application of the invention is not limited to any specific system, but it can be used in connection with various three-phase electric systems to detect a phase-to-earth fault on a three-phase electric line of an electric network. The electric line can be a feeder, for example, and it may be an overhead-line or a cable or a combination of both. The electric power system in which the invention is implemented can be an electric transmission or distribution network or a component thereof, for example, and may comprise several feeders or sections. Moreover, the use of the invention is not limited to systems employing 50 Hz or 60 Hz fundamental frequencies or to any specific voltage level.

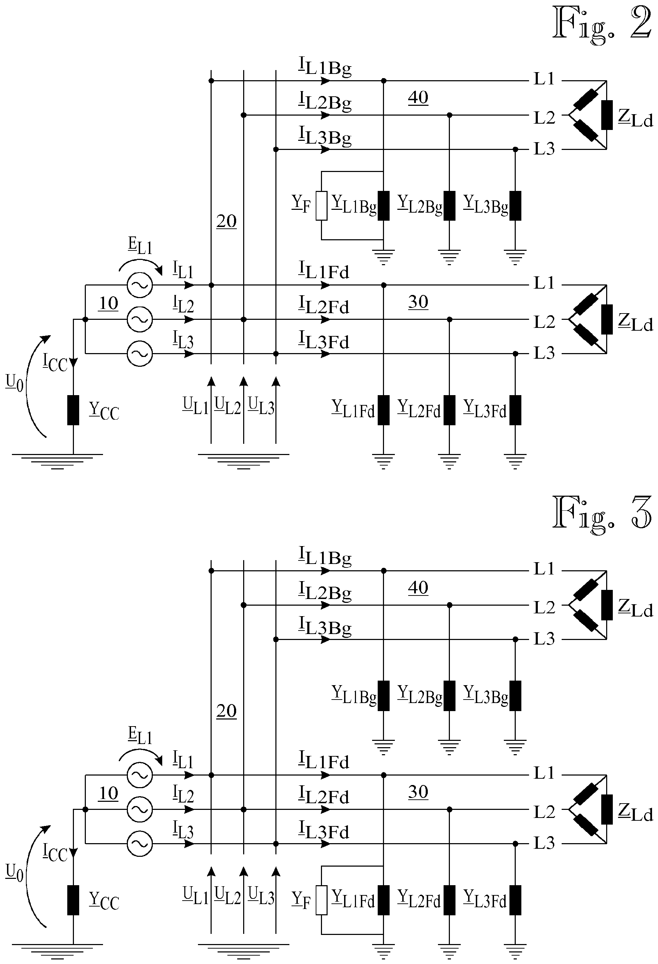

Figures 2 and 3 are simplified equivalent circuits for a three-phase electric network in which the invention can be used. Figure 2 shows a situation in which there is a fault in the background network and Figure 3 shows a situation in which there is a fault in the electric line to be monitored. The figures show only the components necessary for understanding the invention. The exemplary network can be a medium voltage (e.g. 20 kV) distribution network fed through a substation comprising a transformer 10 and a busbar 20. The illustrated network also comprises electric line outlets, i.e. feeders, of which one 30 is shown separately. Other possible feeders as well as other network parts, except the line 30, are referred to as a 'background network' and have been represented by a single line outlet 40 although it should be noted that there may be any number of feeders or other network elements in the background network. There may also be several feeding substations. Further, the invention can be utilized with a switching station without a transformer 10, for example. The network is a three-phase network and the three phases of the three-phase electricity system are referred to as L1, L2, and L3. In the exemplary system the functionality of the invention can be located in a possible relay unit (not shown) located at the beginning of the line 30 e.g. in the connection point between the line 30 and the busbar 20. It is also possible that only some measurements are performed in the location of such a unit and the results are then transmitted to another unit or units in another location for further processing. Thus, the functionality of the invention could be distributed among two or more physical units instead of just one unit and also the unit or units implementing the invention may be located in connection with the electric line 30 to be protected or possibly in a remote location. This, however, has no relevance to the basic idea of the invention. The notations used in Figures 2 and 3 are as follows:

$\underline{U}_0$ = Zero-sequence voltage of the network
$\underline{E}_{L1}$ = Phase L1 source voltage
$\underline{E}_{L2}$ = Phase L2 source voltage
$\underline{E}_{L3}$ = Phase L3 source voltage
$\underline{I}_{CC}$ = Current through the earthing arrangement (compensation coil plus parallel resistor)
$\underline{Y}_{CC}$ = Admittance of the earthing arrangement (compensation coil plus parallel resistor)
$\underline{I}_{L1}$ = Phase current of phase L1 measured at infeed
$\underline{I}_{L2}$ = Phase current of phase L2 measured at infeed
$\underline{I}_{L3}$ = Phase current of phase L3 measured at infeed
$\underline{I}_{L1Fd}$ = Phase current of phase L1 of the electric line
$\underline{I}_{L2Fd}$ = Phase current of phase L2 of the electric line
$\underline{I}_{L3Fd}$ = Phase current of phase L3 of the electric line
$\underline{I}_{L1Bg}$ = Phase current of phase L1 of the background network
$\underline{I}_{L2Bg}$ = Phase current of phase L2 of the background network
$\underline{I}_{L3Bg}$ = Phase current of phase L3 of the background network

$\underline{U}_{L1}$ = Phase voltage of phase L1 at the substation
$\underline{U}_{L2}$ = Phase voltage of phase L2 at the substation
$\underline{U}_{L3}$ = Phase voltage of phase L3 at the substation
$\underline{Y}_{F}$ = Fault admittance (assumed to be pure conductance)
$\underline{Y}_{L1Fd}$ = Admittance of phase L1 of the electric line
$\underline{Y}_{L2Fd}$ = Admittance of phase L2 of the electric line
$\underline{Y}_{L3Fd}$ = Admittance of phase L3 of the electric line
$\underline{Y}_{L1Bg}$ = Admittance of phase L1 of the background network
$\underline{Y}_{L2Bg}$ = Admittance of phase L2 of the background network
$\underline{Y}_{L3Bg}$ = Admittance of phase L3 of the background network
$\underline{Z}_{Ld}$ = Phase impedance of a delta connected load

Monitored current and voltage values are preferably obtained by a suitable measuring arrangement including e.g. current and voltage transducers (not shown in the figures) connected to the phases of the electricity system. In most of the existing protection systems, these values are readily available and thus the implementation of the invention does not necessarily require any separate or specific measuring arrangements. How such values are obtained is of no relevance to the basic idea of the invention and depends on the particular electricity system to be monitored.

The invention utilizes the calculation of neutral admittance $\underline{Y}_0$, that is, the quotient of residual current $3\underline{I}_0$ ($\underline{I}_0$ is the zero sequence current) measured at the beginning of the electric line 30 ($3\underline{I}_0 = \underline{I}_{L1Fd} + \underline{I}_{L2Fd} + \underline{I}_{L3Fd}$) and residual voltage $\underline{U}_0$ (with negative sign). According to an embodiment, the calculation of the neutral admittance is done with "delta"-quantities, where t1 and t2 refer to two separate instances in time, before (t1) and during (t2) the fault:

$$\underline{Y}_{0\Delta} = \frac{3 \cdot (\underline{I}_{0\_t2} - \underline{I}_{0\_t1})}{-(\underline{U}_{0\_t2} - \underline{U}_{0\_t1})} \tag{1}$$

Start of the neutral admittance calculation (e.g. according to equation 1) is preferably done as soon as an earth fault is detected. An earth fault in the electric network may be detected on the basis of the zero sequence voltage. It can be done in two alternative ways: either when amplitude of the residual voltage exceeds a pre-set value $U_{0set}$:

$$\left|\underline{U}_0\right| > U_{0set} \tag{2}$$

or when a change in the residual voltage exceeds a pre-set value $U_{0Dset}$:

$$\left|\underline{U}_{0\_t2}\right| - \left|\underline{U}_{0\_t1}\right| > U_{0\Delta set} \tag{3}$$

The advantage of using equation 3 as a start criterion is the fact that due to network asymmetry, a large magnitude residual voltage may exist in the network during the healthy state. This may lead to a very high value of $U_{0set}$, which in turn results in insensitivity of the fault detection. By applying equation 3, the start criterion is based on change, not on the absolute value, and therefore sensitivity of fault detection is increased.

With reference to Figure 2, when a single-phase earth fault occurs outside the electric line 30, the measured neutral admittance equals to the total line admittance (sum of all phase admittances) with a negative sign:

$$\underline{Y}_{0\Delta} = -\underline{Y}_{Fdtot} = -\left(G_{FDtot} + j \cdot B_{Fdtot}\right) \tag{4}$$

where

$\underline{Y}_{Fdtot}$ = the total line admittance

$G_{Fdtot}$ = the total line conductance

$B_{Fdtot}$ = the total line susceptance

$$\underline{Y}_{Fdtot} = \underline{Y}_{L1Fd} + \underline{Y}_{L2Fd} + \underline{Y}_{L3Fd}$$

$$\underline{Y}_{L1Fd} = G_{L1Fd} + j \cdot B_{L1Fd}$$

$$\underline{Y}_{L2Fd} = G_{L2Fd} + j \cdot B_{L2Fd}$$

$$\underline{Y}_{L3Fd} = G_{L3Fd} + j \cdot B_{L3Fd}$$

$G_{L1Fd}$ = Phase-to-earth conductance of phase L1 of the electric line

$G_{L2Fd}$ = Phase-to-earth conductance of phase L2 of the electric line

$G_{L3Fd}$ = Phase-to-earth conductance of phase L3 of the electric line

$B_{L1Fd}$ = Phase-to-earth susceptance of phase L1 of the electric line

$B_{L2Fd}$ = Phase-to-earth susceptance of phase L2 of the electric line

$B_{L3Fd}$ = Phase-to-earth susceptance of phase L3 of the electric line

In practice, the conductance term real($\underline{Y}_{Fdtot}$) = $G_{Fdtot}$ = ($G_{L1Fd}$ + $G_{L2Fd}$ + $G_{L3Fd}$) is very small due to small resistive leakage losses of conductors. At least in networks with over-headlines, the losses may be so small that conductance cannot be measured accurately. In this case, only the susceptance term imag($\underline{Y}_{Fdtot}$) = $B_{Fdtot}$ = ($B_{L1Fd}$ + $B_{L2Fd}$ + $B_{L3Fd}$) = w·($C_{0L1}$ + $C_{0L2}$ + $C_{0L3}$) is valid. The admittance protection characteristic should be set so that the measured neutral admittance during outside fault stays inside the operation characteristics (= protection does not operate). An outside fault means that the fault is located outside the protected electric line 30. This can be achieved by setting the admittance characteristic so that the characteristic always covers the total line admittance of the electric line. The value for the total line admittance (sum of all phase admittances) can be determined on the basis of the earth-fault current value of the electric line:

$$\underline{Y}_{Fdtot} \approx j^*3 \cdot I_{0Fd}/U_{phase}, \qquad\qquad (5)$$

where

$3 \cdot I_{0Fd}$ = magnitude of the earth-fault current supplied by the line in case of an outside fault ($R_F$ = 0 ohm)
$U_{phase}$ = nominal phase-to-earth voltage of the network

Another option is to determine the total line admittance by calculating the neutral admittance based on changes in the residual current and voltage during the healthy state. These changes can be due to e.g. altering the compensation coil tuning or switching of the parallel resistor of the compensation coil (on or off):

$$\underline{Y}_{Fdtot} = \frac{3 \cdot (\underline{I}_{0\_h2} - \underline{I}_{0\_h1})}{-(\underline{U}_{0\_h2} - \underline{U}_{0\_h1})}, \qquad\qquad (6)$$

where

$3^*\underline{I}_{0\_h1}$ = residual current prior to the change during healthy state
$3^*\underline{I}_{0\_h2}$ = residual current after the change during healthy state
$\underline{U}_{0\_h1}$ = residual voltage prior to the change during healthy state
$\underline{U}_{0\_h2}$ = residual voltage after the change during healthy state

This embodiment has the advantage that admittance characteristic settings could be updated utilizing equation 6 so that the settings, and thus the characteristic, match the current switching state of the electric line i.e. the total line admittance is covered by the admittance characteristic. The updating can be performed in real time, i.e. always when the switching state of the three-phase electric line changes. Alternatively, the updating can be performed at predetermined intervals, for example.

With reference to Figure 3, when a single-phase earth fault occurs inside the electric line 30, the measured neutral admittance equals to the admittance of the background network 40 plus the compensation coil including a parallel resistor:

$$\underline{Y}_{0\Delta} = \underline{Y}_{Bgtot} + \underline{Y}_{CC} \qquad (7)$$

where

$$\underline{Y}_{Bgtot} = \underline{Y}_{L1Bg} + \underline{Y}_{L2Bg} + \underline{Y}_{L3Bg}$$

$$\underline{Y}_{L1Bg} = G_{L1Bg} + j \cdot B_{L1Bg}$$

$$\underline{Y}_{L2Bg} = G_{L2Bg} + j \cdot B_{L2Bg}$$

$$\underline{Y}_{L3Bg} = G_{L3Bg} + j \cdot B_{L3Bg}$$

$G_{L1Bg}$ = Phase-to-earth conductance of phase L1 of the background network

$G_{L2Bg}$ = Phase-to-earth conductance of phase L2 of the background network

$G_{L3Bg}$ = Phase-to-earth conductance of phase L3 of the background network

$B_{L1Bg}$ = Phase-to-earth susceptance of phase L1 of the background network

$B_{L2Bg}$ = Phase-to-earth susceptance of phase L2 of the background network

$B_{L3Bg}$ = Phase-to-earth susceptance of phase L3 of the background network

$$\underline{Y}_{CC} = G_{CC} - j \cdot B_{CC}$$

$G_{CC}$ = Conductance of the earthing arrangement (compensation coil plus parallel resistor)

$B_{CC}$ = Susceptance of the earthing arrangement (compensation coil)

$G_{CC}$ is the conductance of the resistor, which is connected in parallel with the compensation coil in case of compensated networks. In case of resistor earthed networks $B_{CC} = 0$ and $G_{CC}$ is the conductance of the earthing resistor. In case of an unearthed network $\underline{Y}_{CC} = 0$. The admittance protection characteristic should be set so that the measured neutral admittance during an inside fault moves outside the operation characteristics (= protection operates). An inside fault means that the fault is located inside the protected electric line 30.

In case of a compensated network and when the compensation coil is adjusted to a resonance ($B_{CC} = B_{Bgtot} + B_{Fdtot}$), the measured neutral admittance calculated with delta quantities is:

$$\underline{Y}_{0\Delta} = (G_{Bgtot} + G_{CC}) - j \cdot B_{Fdtot} \qquad (8)$$

This is the most difficult case of discriminating outside and inside fault as imaginary part of measured neutral admittance is the same in both cases. Secure and reliable protection might require that resistive current is increased during the fault by the use of a parallel resistor. Neutral admittance calculation can then measure the conductance of the parallel resistor. Therefore the discrimination should be done on the basis of conductance.

According to an embodiment, once the neutral admittance, or a quantity indicative thereof, has been determined e.g. on the basis of equation 1, it is compared to a predetermined operation characteristic to detect a phase-to-earth fault on the three-phase electric line 30. According to an embodiment, the predetermined operation characteristic, when presented on an admittance plane, defines a closed area such that the centre of the closed area is offset from the origin of the admittance plane towards a negative susceptance direction and/or towards a negative conductance direction. The comparison of the determined neutral admittance, or the quantity indicative thereof, to a predetermined operation characteristic to detect a phase-to-earth fault on the three-phase electric line preferably comprises determining whether the neutral admittance is inside or outside of said closed area defined by the predetermined operation characteristic on the admittance plane, and detecting a phase-to-earth fault on the three-phase electric line when the determined neutral admittance is determined to be outside of said closed area defined by the predetermined operation characteristic on the admittance plane. In other words, the closed area is a non-operation area in which the protection does not operate, and the area outside the closed area is an operation area in which the protection operates i.e. a phase-to-earth fault is detected on the three-phase electric line 30.

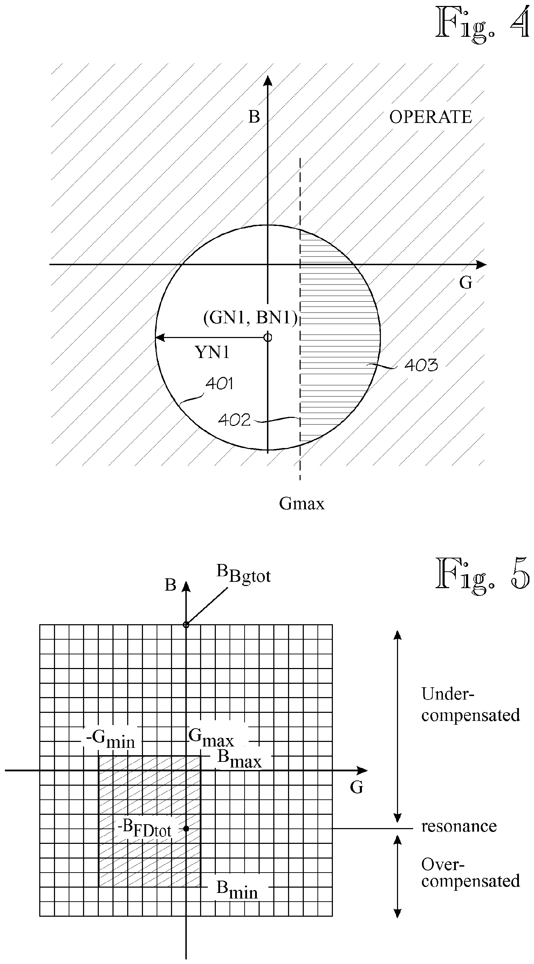

According to an embodiment, the closed area is defined by a circle or an ellipse whose centre point is offset from the origin of the admittance plane towards the negative susceptance (B) direction and/or towards the negative conductance (G) direction. Figure 4 shows an example of an operation characteristic which comprises a circle 401, which is set-off from the admittance plane origin by settings GN1 and BN1. The circle radius is defined by setting YN1. Operation of the protection is achieved, when the determined neutral admittance moves outside the closed area defined by the circle 401. In mathematical form this can be expressed as follows:

$$real(\underline{Y}_{0\Delta}) - GN1)^2 + (imag(\underline{Y}_{0\Delta}) - BN1)^2 - YN1 \cdot YN1 > 0 \,, \qquad (9)$$

where $\underline{Y}_{0\Delta}$ is the measured neutral admittance.

The settings GN1, BN1 and YN1 should be generally selected such that the admittance corresponding to the electric line 30 length ($\underline{Y}_{Fdtot}$) is within the closed area preferably with a suitable safety margin. The smaller the circle, the more sensitive the protection is. If the connection state of the electric line 30 to be protected changes, the settings should be adjusted accordingly. This can also be done automatically by determining the total line admittance by calculating the neutral admittance based on changes in the residual current and voltage during the healthy state using equation 6. After determining the total line admittance of the present switching state using equation 6, the settings GN1, BN1 and YN1 can be updated according to the following criteria:

$$BN1 = -imag(\underline{Y}_{Fdtot})$$

$$GN1 = -real(\underline{Y}_{Fdtot})$$

$$YN1 = r*imag(\underline{Y}_{Fdtot})$$

r = factor defining the marginal (sensitivity) of the protection, r > 0. In Figure 4, r = 1.5.
r = user defined setting parameter

According to an embodiment, the closed area is defined by a circle whose centre point is offset from the origin of the admittance plane towards the negative susceptance direction and/or towards the negative conductance direction such that a segment of the circle is excluded from the closed area which segment is defined by a line defined by a predetermined conductance value. In other words, in practical applications the offset admittance circle 401 can be combined with one or more "classical" boundary lines, e.g. with a forward directional conductance boundary line 402 as illustrated in Figure 4. The value for $G_{max}$ can be obtained from parallel resistor conductance: $G_{max} = k*G_{CC}$, where k = 0...1 safety margin. Typical value for k is 0.8. In this case the shaded segment 403 of the circle 401 is excluded from the closed area and thus belongs to the operation area surrounding the closed non-operation area. In case the network is a compensated one and $|YN1|>|G_{CC}|$, $G_{max}$ should be preferably set and used. However, if the compensation coil and parallel resistor are disconnected, this setting need not be changed.

According to an embodiment, the closed area is a polygon having three or more sides defined by three or more lines, respectively. This is exemplified in Figure 5 in which the operation characteristic is an off-set rectangle (the shaded area), whose reach is defined by settings $B_{min}$, $B_{max}$ and $G_{min}$, $G_{max}$ which define lines forming the sides of the rectangle. This operation scheme requires more setting parameters, but offers more flexibility and is useful especially in case of problematic network configurations. In practice, the G settings relate to the network components causing resistive current in the network such as a possible compensation coil and its parallel resistor. In case of a compensated network when the fault is in the protected electric line, the admittance determination detects:

$$\underline{Y}_{0\Delta} = \underline{Y}_{Bgtot} + \underline{Y}_{CC} = (G_{Bgtot} + j \cdot B_{Bgtot}) + (G_{CC} - j \cdot B_{CC})$$

As typically $G_{CC} \gg G_{Bgtot}$, the following approximation is valid in practice:

$$\underline{Y}_{0\Delta} \approx G_{CC} + j \cdot (B_{Bgtot} - B_{CC})$$

In other words, the imaginary part of the measured admittance is mainly due to the term $G_{CC}$ caused by the parallel resistor of the compensation coil. Thus, the settings $G_{min}$ and $G_{max}$ are preferably selected such that Gcc is outside the range defined by $G_{min}$ and $G_{max}$. A suitable safety margin may be used. The settings $B_{min}$ and $B_{max}$ may be selected e.g. to correspond to the minimum and maximum switching situations of the electric line 30 to be protected. Again, a suitable safety margin may be used.

One option is to determine parameters of a polygon shape admittance criterion by utilizing calculated neutral admittance based on changes in the residual current and voltage during the healthy state using equation 6. After determining the total line admittance of the present switching state using equation 6, then settings $G_{min}$, $G_{max}$, $B_{min}$ and $B_{max}$ can be determined using the following formulae:

$G_{max}$ =    The value for $G_{max}$ can be obtained from parallel resistor conductance: $G_{max} = k*G_{CC}$, where $k = 0...1$ is a safety margin. Typical value for k is 0.8.

$G_{min}$ =    d*imag($\underline{Y}_{Fdtot}$), where d is a factor defining the marginal (sensitivity) of the protection. d > 0, in Figure 5, d = 1.5.

$B_{min}$ =    q1*imag($\underline{Y}_{Fdtot}$), where q1 is a factor defining the marginal (sensitivity) of the protection. q1 > 0, in Figure 5, d = 1.0.

$B_{max}$ =    q2*imag($\underline{Y}_{Fdtot}$), where q2 is a factor defining the marginal (sensitivity) of the protection. q2 > 0, in Figure 5, d = 1.25.

d, q1, q2    are user defined setting parameters.

The benefit of the various suggested operation characteristics is that they can be applied to unearthed, high resistance earthed and also compensated networks. Also the number of settings is minimized. In addition, the setting procedure is very simple as B-axis settings can be calculated on the basis of earth fault current supplied by the electric line using equation 5 and G-axis settings can be based on a rated value of earthing/parallel resistor current $I_{GCC}$: ($G_{min}$ = k·$I_{GCC}$/$U_{phase}$). Example: $I_{GCC}$ = 5A, $U_{phase}$ = 20000/sqrt(3) volts, k = 0.5: $G_{min}$ = 0.22 milliSiemens. Alternatively, settings can be determined utilizing changes during the healthy state and using equation 6.

According to an embodiment, the fault resistance can be simultaneously (during a fault inside the electric line) estimated with the equation:

$$\underline{Y}_F = \frac{3 \cdot \underline{I}_{0\Delta} - \underline{U}_{0\Delta} \cdot \underline{Y}_{Fdtot}}{\underline{U}_{L\_fault}} \Rightarrow R_F = \frac{1}{real(\underline{Y}_F)} , \qquad (10)$$

where $L_{L\_fault}$ is the phase-to-earth voltage of the faulted phase during a fault

Equation 10 uses the same measured quantities and the settings $\underline{Y}_{0Fdtot}$ = $G_{Fdtot}$ + j·$B_{Fdtot}$ as the protection. Another option to calculate the fault resistance is to calculate the fault admittance with delta method utilizing changes during the fault:

$$\underline{Y}_F = \frac{3 \cdot (\underline{I}_{0\_f2} - \underline{I}_{0\_f1})}{-(\underline{U}_{0\_f2} - \underline{U}_{0\_f1})} - \underline{Y}_{Fdtot} \Rightarrow R_F = \frac{1}{real(\underline{Y}_F)} , \qquad (11)$$

where f1 and f2 refer to two separate instances in time during the fault, before (f1) and after (f2) the change. This change can be due to e.g. altering the compensation coil tuning or switching of the parallel resistor of the compensation coil (on or off).

According to an embodiment, also a faulted phase can be identified by calculating fault resistance estimates simultaneously for each phase:

$$R_{F\_L1} = real(\frac{\underline{U}_{L1\_fault}}{3 \cdot \underline{I}_{0\Delta} - \underline{U}_{0\Delta} \cdot \underline{Y}_{Fdtot}})$$

$$R_{F\_L2} = real(\frac{\underline{U}_{L2\_fault}}{3 \cdot \underline{I}_{0\Delta} - \underline{U}_{0\Delta} \cdot \underline{Y}_{Fdtot}})$$

$$R_{F\_L3} = real(\frac{\underline{U}_{L3\_fault}}{3 \cdot \underline{I}_{0\Delta} - \underline{U}_{0\Delta} \cdot \underline{Y}_{Fdtot}})$$

Phase selection logic suggested: in case only one out of the three fault resistance estimates provides positive value, this is the faulted phase with corresponding fault resistance value. In case two out of the three fault resistance estimates provides positive value, the faulted phase is selected on the basis of comparing the phase voltage magnitudes between the two candidates: the faulted phase is the phase with a lower phase voltage value.

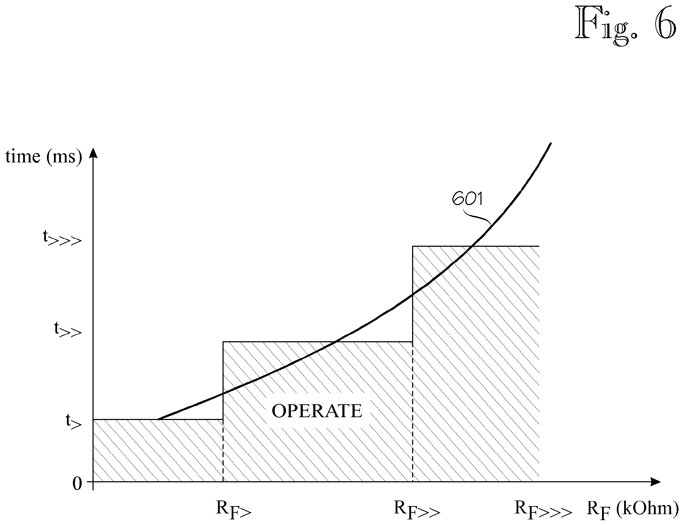

According to an embodiment, a multi-stage admittance protection concept could be implemented. When the faulted electric line is detected on the basis of the admittance criteria, the fault resistance estimate can be used to define operation speed. Multiple fault resistance thresholds (protection stages) could be implemented. Different stages could be set e.g. at RF>, RF>>, RF>>>, RF>>>> with corresponding protection operation delays t>, t», t>>> and t>>>>. This is illustrated in Figure 6, which shows how an inverse type operation curve 601 is formed along with such protection stages.

An apparatus according to any one of the above embodiments, or a combination thereof, may be implemented as one unit or as two or more separate units that are configured to implement the functionality of the various embodiments. Here the term 'unit' refers generally to a physical or logical entity, such as a physical device or a part thereof or a software routine. One or more of these units may reside in a protective relay device or equipment, for example. For example, an apparatus according to an embodiment may comprise a monitoring unit configured to monitor a zero sequence current on the three-phase electric line and a zero sequence voltage in the electric network; a detection unit configured to detect an earth fault in the electric network on the basis of the zero sequence voltage value, a determination unit configured to determine a difference between the zero sequence current before the earth fault and the zero sequence current during the earth fault, to determine a difference between the zero sequence voltage before the earth fault and the zero sequence voltage during the earth fault, and to determine a neutral admittance, or a quantity indicative thereof, on the basis of a ratio between the difference between the zero sequence currents and the difference between the zero sequence voltages, and a comparison unit configured to compare the determined neutral admittance, or the quantity indicative thereof, to a predetermined operation characteristic to detect a phase-to-earth fault on the three-phase electric line.

An apparatus according to any one of the embodiments may be implemented by means of a computer or corresponding digital signal processing equipment provided with suitable software, for example. Such a computer or digital signal processing equipment preferably comprises at least a working memory (RAM) providing storage area for arithmetical operations and a central processing unit (CPU), such as a general-purpose digital signal processor. The CPU may comprise a set of registers, an arithmetic logic unit, and a control unit. The control unit is controlled by a sequence of program instructions transferred to the CPU from the RAM. The control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention further preferably comprises suitable input means for receiving e.g. measurement and/or control data, which input means thus enable e.g. the monitoring of current and voltage quantities, and output means for outputting e.g. fault alarms and/or control data e.g. for controlling protection equipment such as switches, disconnectors and circuit-breakers. It is also possible to use a specific integrated circuit or circuits, and/or discrete components and devices for implementing the functionality according to any one of the embodiments.

The invention can be implemented in existing system elements, such as various protective relays or similar devices, or by using separate dedicated elements or devices in a centralized or distributed manner. Present protective devices for electric systems, such as protective relays, typically comprise processors and memory that can be utilized in the functions according to embodiments of the invention. Thus, all modifications and configurations required for implementing an embodiment of the invention e.g. in existing protective devices may be performed as software routines, which may be implemented as added or updated software routines. If the functionality of the invention is implemented by software, such software can be provided as a computer program product comprising computer program code which, when run on a computer, causes the computer or corresponding arrangement to perform the functionality according to the invention as described above. Such a computer program code may be stored or generally embodied on a computer readable medium, such as suitable memory, e.g. a flash memory or a disc memory from which it is loadable to the unit or units executing the program code. In addition, such a computer program code implementing the invention may be loaded to the unit or units executing the computer program code via a suitable data network, for example, and it may replace or update a possibly existing program code.

It will be obvious to a person skilled in the art that, as the technology advances, the inventive concept may be implemented in various ways. The invention and its embodiments are not limited to the examples described above but may vary within the scope of the claims.

## Claims

1. A method for detecting a phase-to-earth fault on a three-phase electric line of an electric network, the method comprising:

   monitoring a zero sequence current on the three-phase electric line and a zero sequence voltage in the electric network;
   detecting an earth fault in the electric network on the basis of the zero sequence voltage value;
   determining a difference between the zero sequence current before the earth fault and the zero sequence current during the earth fault; and
   determining a difference between the zero sequence voltage before the earth fault and the zero sequence voltage during the earth fault, **characterized in that** the method comprises:

   determining a neutral admittance, or a quantity indicative thereof, on the basis of a ratio between the difference between the zero sequence currents and the difference between the zero sequence voltages; and
   comparing the determined neutral admittance, or the quantity indicative thereof, to a predetermined operation characteristic to detect a phase-to-earth fault on the three-phase electric line, wherein the predetermined operation characteristic, when presented on an admittance plane, defines a closed area such that the centre of the closed area is offset from the origin of the admittance plane towards a negative susceptance direction and/or towards a negative conductance direction.

2. A method according to claim 1, **characterized in that**
   the comparing of the determined neutral admittance, or the quantity indicative thereof, to a predetermined operation characteristic to detect a phase-to-earth fault on the three-phase electric line comprises:

   determining whether the neutral admittance is inside or outside said closed area defined by the predetermined operation characteristic on the admittance plane; and
   detecting a phase-to-earth fault on the three-phase electric line when the determined neutral admittance is determined to be outside said closed area defined by the predetermined operation characteristic on the admittance plane.

3. A method according to claim 1 or 2, **characterized in that** the closed area is defined by a circle or an ellipse whose centre point is offset from the origin of the admittance plane towards the negative susceptance direction and/or towards the negative conductance direction.

4. A method according to claim 1 or 2, **characterized in that** the closed area is defined by a circle whose centre point is offset from the origin of the admittance plane towards the negative susceptance direction and/or towards the negative conductance direction such that a segment of the circle is excluded from the closed area, which segment is defined by a line defined by a predetermined conductance value.

5. A method according to claim 1 or 2, **characterized in that** the closed area is a polygon having three or more sides defined by three or more lines respectively.

**6.** A method according to any one of claims 1 to 5, **characterized in that** the method comprises updating the predetermined operation characteristic when the switching state of the three-phase electric line changes or at predetermined intervals.

**7.** A computer program product comprising computer program code, wherein the execution of the program code in a computer causes the computer to carry out the steps of the method according to any one of claims 1 to 6.

**8.** An apparatus for detecting a phase-to-earth fault on a three-phase electric line (30) of an electric network, the apparatus comprising:

means for monitoring a zero sequence current on the three-phase electric line (30) and a zero sequence voltage in the electric network;
means for detecting an earth fault in the electric network on the basis of the zero sequence voltage value;
means for determining a difference between the zero sequence current before the earth fault and the zero sequence current during the earth fault; and
means for determining a difference between the zero sequence voltage before the earth fault and the zero sequence voltage during the earth fault, **characterized in that** the apparatus comprises:

means for determining a neutral admittance, or a quantity indicative thereof, on the basis of a ratio between the difference between the zero sequence currents and the difference between the zero sequence voltages; and
means for comparing the determined neutral admittance, or the quantity indicative thereof, to a predetermined operation characteristic to detect a phase-to-earth fault on the three-phase electric line, wherein the predetermined operation characteristic, when presented on an admittance plane, defines a closed area such that the centre of the closed area is offset from the origin of the admittance plane towards a negative susceptance direction and/or towards a negative conductance direction.

**9.** An apparatus according to claim 8, **characterized in that**
the means for comparing the determined neutral admittance, or the quantity indicative thereof, to a predetermined operation characteristic to detect a phase-to-earth fault on the three-phase electric line comprises:

means for determining whether the neutral admittance is inside or outside said closed area defined by the predetermined operation characteristic on the admittance plane; and
means for detecting a phase-to-earth fault on the three-phase electric line when the determined neutral admittance is determined to be outside said closed area defined by the predetermined operation characteristic on the admittance plane.

**10.** An apparatus according to claim 8 or 9, **characterized in that** the closed area is defined by a circle or an ellipse whose centre point is offset from the origin of the admittance plane towards the negative susceptance direction and/or towards the negative conductance direction.

**11.** An apparatus according to claim 8 or 9, **characterized in that** the closed area is defined by a circle whose centre point is offset from the origin of the admittance plane towards the negative susceptance direction and/or towards the negative conductance direction such that a segment of the circle is excluded from the closed area which segment is defined by a line defined by a predetermined conductance value.

**12.** An apparatus according to claim 8 or 9, **characterized in that** the closed area is a polygon having three or more sides defined by three or more lines respectively.

**13.** An apparatus as claimed in any one of claims 8 to 12, **characterized in that** the apparatus comprises means for updating the predetermined operation characteristic when the switching state of the three-phase electric line changes or at predetermined intervals.

**14.** An apparatus as claimed in any one of claims 8 to 13, **characterized in that** the apparatus comprises a protective relay.

**Patentansprüche**

1. Verfahren zum Erfassen eines Phasenerdschlusses an einer dreiphasigen elektrischen Leitung eines elektrischen Netzwerks, wobei das Verfahren umfasst:

   Überwachen eines Nullsequenzstroms auf der dreiphasigen elektrischen Leitung und einer Nullsequenzspannung in dem elektrischen Netz;
   Erfassen eines Erdschlusses in dem elektrischen Netz auf der Grundlage des Nullsequenzspannungswertes;
   Bestimmen einer Differenz zwischen dem Nullsequenzstrom vor dem Erdschluss und dem Nullsequenzstrom während des Erdschlusses; und
   Bestimmen einer Differenz zwischen der Nullsequenzspannung vor dem Erdschluss und der Nullsequenzspannung während des Erdschlusses, **dadurch gekennzeichnet, dass** das Verfahren umfasst:

   Bestimmen einer neutralen Admittanz oder einer dafür indikativen Größe auf der Grundlage eines Verhältnisses zwischen der Differenz zwischen den Nullsequenzströmen und der Differenz zwischen den Nullsequenzspannungen; und
   Vergleichen der ermittelten neutralen Admittanz oder der dafür indikativen Größe mit einer vorbestimmten Betriebscharakteristik, um einen Phasenerdschluss an der dreiphasigen elektrischen Leitung zu erfassen, wobei die vorbestimmte Betriebscharakteristik, wenn sie auf einer Admittanzebene dargestellt ist, einen geschlossenen Bereich definiert, so dass der Mittelpunkt des geschlossenen Bereichs von dem Ursprung der Admittanzebene zu einer negativen Blindleitrichtung und/oder zu einer negativen Leitungsrichtung versetzt ist.

2. Verfahren nach Anspruch 1, **dadurch gekennzeichnet, dass** das Vergleichen der ermittelten neutralen Admittanz oder der dafür indikativen Größe mit einer vorbestimmten Betriebscharakteristik, um einen Phasenerdschluss auf der dreiphasigen elektrischen Leitung zu erfassen, umfasst:

   Bestimmen, ob die neutrale Admittanz innerhalb oder außerhalb des geschlossenen Bereichs ist, der durch die vorbestimmte Betriebscharakteristik auf der Admittanzebene definiert ist; und
   Erfassen eines Phasenerdschlusses an der dreiphasigen elektrischen Leitung, wenn festgestellt wird, dass die ermittelte neutrale Admittanz außerhalb des geschlossenen Bereichs liegt, der durch die vorbestimmte Betriebscharakteristik auf der Admittanzebene definiert ist.

3. Verfahren nach Anspruch 1 oder 2, **dadurch gekennzeichnet, dass** der geschlossene Bereich durch einen Kreis oder eine Ellipse definiert ist, dessen bzw. deren Mittelpunkt vom Ursprung der Admittanzebene zu der negativen Blindleitrichtung und/oder zu der negativen Leitungsrichtung versetzt ist.

4. Verfahren nach Anspruch 1 oder 2, **dadurch gekennzeichnet, dass** der geschlossene Bereich durch einen Kreis definiert ist, dessen Mittelpunkt vom Ursprung der Admittanzebene zu der negativen Blindleitrichtung und/oder zu der negativen Leitungsrichtung versetzt ist, so dass ein Segment des Kreises aus dem geschlossenen Bereich ausgeschlossen ist, wobei dieses Segment durch eine durch einen vorbestimmten Leitwert definierte Linie definiert ist.

5. Verfahren nach Anspruch 1 oder 2, **dadurch gekennzeichnet, dass** der geschlossene Bereich ein Polygon mit drei oder mehr Seiten ist, die jeweils durch drei oder mehr Linien definiert sind.

6. Verfahren nach einem der Ansprüche 1 bis 5, **dadurch gekennzeichnet, dass** das Verfahren das Aktualisieren der vorbestimmten Betriebscharakteristik umfasst, wenn sich der Schaltzustand der dreiphasigen elektrischen Leitung ändert, oder in vorbestimmten Intervallen.

7. Computerprogrammprodukt, das einen Computerprogrammcode umfasst, wobei die Ausführung des Programmcodes in einem Computer den Computer veranlasst, die Schritte des Verfahrens nach einem der Ansprüche 1 bis 6 auszuführen.

8. Gerät zum Erfassen eines Phasenerdschlusses an einer dreiphasigen elektrischen Leitung (30) eines elektrischen Netzes, wobei das Gerät umfasst:

   Mittel zum Überwachen eines Nullsequenzstroms auf der dreiphasigen elektrischen Leitung (30) und einer Nullsequenzspannung in dem elektrischen Netzwerk;

Mittel zum Erfassen eines Erdschlusses in dem elektrischen Netz auf der Grundlage des Nullsequenzspannungswertes;

Mittel zum Bestimmen einer Differenz zwischen dem Nullsequenzstrom vor dem Erdschluss und dem Nullsequenzstrom während des Erdschlusses; und

Mittel zum Bestimmen einer Differenz zwischen der Nullsequenzspannung vor dem Erdschluss und der Nullsequenzspannung während des Erdschlusses, **dadurch gekennzeichnet, dass** das Gerät umfasst:

Mittel zum Bestimmen einer neutralen Admittanz oder einer dafür indikativen Größe auf der Grundlage eines Verhältnisses zwischen der Differenz zwischen den Nullsequenzströmen und der Differenz zwischen den Nullsequenzspannungen; und

Mittel zum Vergleichen der ermittelten neutralen Admittanz oder der dafür indikativen Größe mit einer vorbestimmten Betriebscharakteristik, um einen Phasenerdschluss an der dreiphasigen elektrischen Leitung zu erfassen, wobei die vorbestimmte Betriebscharakteristik, wenn sie auf einer Admittanzebene dargestellt ist, eine geschlossene Fläche definiert, so dass der Mittelpunkt des geschlossenen Bereichs vom Ursprung der Admittanzebene zu einer negativen Blindleitrichtung und/oder zu einer negativen Leitungsrichtung hin versetzt ist.

9.  Gerät nach Anspruch 8, **dadurch gekennzeichnet, dass** die Mittel zum Vergleichen der ermittelten neutralen Admittanz oder der dafür indikativen Größe mit einer vorbestimmten Betriebscharakteristik, um einen Phasenerdschluss an der dreiphasigen elektrischen Leitung zu erfassen, umfasst:

Mittel zum Bestimmen, ob die neutrale Admittanz innerhalb oder außerhalb des geschlossenen Bereichs ist, der durch die vorbestimmte Betriebscharakteristik auf der Admittanzebene definiert ist; und

Mittel zum Erfassen eines Phasenerdschlusses an der dreiphasigen elektrischen Leitung, wenn festgestellt wird, dass die ermittelte neutrale Admittanz außerhalb des geschlossenen Bereichs liegt, der durch die vorbestimmte Betriebscharakteristik auf der Admittanzebene definiert ist.

10. Gerät nach Anspruch 8 oder 9, **dadurch gekennzeichnet, dass** der geschlossene Bereich durch einen Kreis oder eine Ellipse definiert ist, dessen oder deren Mittelpunkt vom Ursprung der Admittanzebene zu der negativen Blindleitrichtung und/oder zu der negativen Leitrichtung hin versetzt ist.

11. Gerät nach Anspruch 8 oder 9, **dadurch gekennzeichnet, dass** der geschlossene Bereich durch einen Kreis definiert ist, dessen Mittelpunkt vom Ursprung der Admittanzebene zu der negativen Blindleitrichtung und/oder zu der negativen Leitungsrichtung versetzt ist, so dass ein Segment des Kreises aus dem geschlossenen Bereich ausgeschlossen ist, wobei das Segment durch eine durch einen vorbestimmten Leitwert definierte Linie definiert ist.

12. Gerät nach Anspruch 8 oder 9, **dadurch gekennzeichnet, dass** der geschlossene Bereich ein Polygon mit drei oder mehr Seiten ist, die jeweils durch drei oder mehr Linien definiert sind.

13. Gerät nach einem der Ansprüche 8 bis 12, **dadurch gekennzeichnet, dass** das Gerät Mittel zum Aktualisieren der vorbestimmten Betriebscharakteristik umfasst, wenn sich der Schaltzustand der dreiphasigen elektrischen Leitung ändert, oder in vorbestimmten Intervallen.

14. Gerät nach einem der Ansprüche 8 bis 13, **dadurch gekennzeichnet, dass** das Gerät ein Schutzrelais umfasst.


**Revendications**

1.  Procédé de détection d'un défaut de phase à la terre sur une ligne électrique triphasée d'un réseau électrique, le procédé comprenant :

la surveillance d'un courant de séquence homopolaire sur la ligne électrique triphasée et d'une tension de séquence homopolaire dans le réseau électrique ;

la détection d'un défaut à la terre dans le réseau électrique sur la base de la valeur de tension de séquence homopolaire ;

la détermination d'une différence entre le courant de séquence homopolaire avant le défaut à la terre et le courant de séquence homopolaire pendant le défaut à la terre ; et

la détermination d'une différence entre la tension de séquence homopolaire avant le défaut à la terre et la tension de séquence homopolaire pendant le défaut à la terre, **caractérisé en ce que** le procédé comprend :

la détermination d'une admittance neutre, ou d'une quantité indicative associée, sur la base d'un rapport entre la différence entre les courants de séquence homopolaire et la différence entre les tensions de séquence homopolaire ; et

la comparaison de l'admittance neutre déterminée, ou de la quantité indicative associée, à une caractéristique de fonctionnement prédéfinie pour détecter un défaut de phase à la terre sur la ligne électrique triphasée, la caractéristique de fonctionnement prédéfinie, lorsqu'elle est présentée sur un plan d'admittance, définissant une zone fermée de sorte que le centre de la zone fermée soit décalé de l'origine du plan d'admittance vers une direction de susceptance négative et/ou vers une direction de conductance négative.

2. Procédé selon la revendication 1, **caractérisé en ce que** la comparaison de l'admittance neutre déterminée, ou de la quantité indicative associée, à une caractéristique de fonctionnement prédéfinie pour détecter un défaut de phase à la terre sur la ligne électrique triphasée comprend :

déterminer si l'admittance neutre est à l'intérieur ou à l'extérieur de ladite zone fermée définie par la caractéristique de fonctionnement prédéfinie sur le plan d'admittance ; et

détecter un défaut de phase à la terre sur la ligne électrique triphasée lorsque l'admittance neutre déterminée est déterminée comme étant en dehors de ladite zone fermée définie par la caractéristique de fonctionnement prédéfinie sur le plan d'admittance.

3. Procédé selon la revendication 1 ou 2, **caractérisé en ce que** la zone fermée est définie par un cercle ou une ellipse dont le point central est décalé de l'origine du plan d'admittance vers la direction de susceptance négative et/ou vers la direction de conductance négative.

4. Procédé selon la revendication 1 ou 2, **caractérisé en ce que** la zone fermée est définie par un cercle dont le point central est décalé de l'origine du plan d'admittance vers la direction de susceptance négative et/ou vers la direction de conductance négative de sorte qu'un segment du cercle soit exclu de la zone fermée, lequel segment est défini par une ligne définie par une valeur de conductance prédéfinie.

5. Procédé selon la revendication 1 ou 2, **caractérisé en ce que** la zone fermée est un polygone ayant trois côtés ou plus définis par trois lignes ou plus respectivement.

6. Procédé selon l'une quelconque des revendications 1 à 5, **caractérisé en ce que** le procédé comprend la mise à jour de la caractéristique de fonctionnement prédéfinie lorsque l'état de commutation de la ligne électrique triphasée change ou à des intervalles prédéfinis.

7. Produit-programme informatique comprenant un code de programme informatique, dans lequel l'exécution du code de programme dans un ordinateur amène l'ordinateur à réaliser les étapes du procédé selon l'une quelconque des revendications 1 à 6.

8. Appareil de détection d'un défaut de phase à la terre sur une ligne électrique triphasée (30) d'un réseau électrique, l'appareil comprenant :

des moyens permettant la surveillance d'un courant de séquence homopolaire sur la ligne électrique triphasée (30) et d'une tension de séquence homopolaire dans le réseau électrique ;

des moyens permettant la détection d'un défaut à la terre dans le réseau électrique sur la base de la valeur de tension de séquence homopolaire ;

des moyens permettant la détermination d'une différence entre le courant de séquence homopolaire avant le défaut à la terre et le courant de séquence homopolaire pendant le défaut à la terre ; et

des moyens permettant la détermination d'une différence entre la tension de séquence homopolaire avant le défaut à la terre et la tension de séquence homopolaire pendant le défaut à la terre, **caractérisé en ce que** l'appareil comprend :

des moyens permettant la détermination d'une admittance neutre, ou d'une quantité indicative associée, sur la base d'un rapport entre la différence entre les courants de séquence homopolaire et la différence entre les tensions de séquence homopolaire ; et

des moyens permettant la comparaison de l'admittance neutre déterminée, ou de la quantité indicative associée, à une caractéristique de fonctionnement prédéfinie pour détecter un défaut de phase à la terre sur la ligne électrique triphasée, la caractéristique de fonctionnement prédéfinie, lorsqu'elle est présentée sur un plan d'admittance, définissant une zone fermée de sorte que le centre de la zone fermée soit décalé de l'origine du plan d'admittance vers une direction de susceptance négative et/ou vers une direction de conductance négative.

9. Appareil selon la revendication 8, **caractérisé en ce que**

les moyens permettant la comparaison de l'admittance neutre déterminée, ou de la quantité indicative associée, à une caractéristique de fonctionnement prédéfinie pour détecter un défaut de phase à la terre sur la ligne électrique triphasée comprennent :

des moyens permettant de déterminer si l'admittance neutre est à l'intérieur ou à l'extérieur de ladite zone fermée définie par la caractéristique de fonctionnement prédéfinie sur le plan d'admittance ; et

des moyens permettant de détecter un défaut de phase à la terre sur la ligne électrique triphasée lorsque l'admittance neutre déterminée est déterminée comme étant en dehors de ladite zone fermée définie par la caractéristique de fonctionnement prédéfinie sur le plan d'admittance.

10. Appareil selon la revendication 8 ou 9, **caractérisé en ce que** la zone fermée est définie par un cercle ou une ellipse dont le point central est décalé de l'origine du plan d'admittance vers la direction de susceptance négative et/ou vers la direction de conductance négative.

11. Appareil selon la revendication 8 ou 9, **caractérisé en ce que** la zone fermée est définie par un cercle dont le point central est décalé de l'origine du plan d'admittance vers la direction de susceptance négative et/ou vers la direction de conductance négative de sorte qu'un segment du cercle soit exclu de la zone fermée, lequel segment est défini par une ligne définie par une valeur de conductance prédéfinie.

12. Appareil selon la revendication 8 ou 9, **caractérisé en ce que** la zone fermée est un polygone ayant trois côtés ou plus définis par trois lignes ou plus respectivement.

13. Appareil selon l'une quelconque des revendications 8 à 12, **caractérisé en ce que** l'appareil comprend des moyens pour mettre à jour la caractéristique de fonctionnement prédéfinie lorsque l'état de commutation de la ligne électrique triphasée change ou à des intervalles prédéfinis.

14. Appareil selon l'une quelconque des revendications 8 à 13, **caractérisé en ce que** l'appareil comprend un relais de protection.

Fig. 1

Fig. 2

Fig. 3

Fig. 4

B

OPERATE

(GN1, BN1)

YN1

401

402

403

G

Gmax

Fig. 5

B$_{Bgtot}$

B

Under-
compensated

-G$_{min}$   G$_{max}$

B$_{max}$

G

-B$_{FDtot}$

resonance

Over-
compensated

B$_{min}$

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1195875 A2

**Non-patent literature cited in the description**

- **J. LORENC.** Admittance criteria for earth fault detection in substation automation systems in Polish distribution power networks. *CIRED 97,* June 1997